# EUROPEAN PATENT SPECIFICATION

(11) **EP 4 143 585 B1**
(45) Date of publication and mention of the grant of the patent: **04.06.2025**
(21) Application number: 21722997.0
(22) Date of filing: 20.04.2021
(51) Int. Cl.: G01R 1/067, G01R 1/073, G01R 31/28

(54) **DEVICE FOR TESTING A PRINTED CIRCUIT BOARD**
VORRICHTUNG ZUM TESTEN EINER LEITERPLATTE
DISPOSITIF DE TEST D'UNE CARTE DE CIRCUIT IMPRIMÉ

(30) Priority: 27.04.2020 BE 202005277
(43) Date of publication of application: 08.03.2023
(73) Proprietor: IPTE Factory Automation N.V., 3600 Genk (BE)
(72) Inventor: GEURTS, Tom, 3540 Schulen (BE); HAENEN, Gilbert Victor François, 3742 Bilzen (BE)
(74) Representative: Arnold & Siedsma
(86) International application number: PCT/IB2021/053234
(87) International publication number: WO 2021/220105

(56) References cited:
- EP-A1- 0 135 384
- WO-A1-01/31348
- DE-A1- 19 907 727
- DE-A1- 3 906 691
- DE-C1- 19 811 795
- JP-A- 2004 093 333
- JP-A- H02 150 773
- US-A- 3 731 191

## Description

The invention relates to a device for testing a printed circuit board.

The invention relates more specifically to a device for testing a printed circuit board, the device comprising a contact plate and a plurality of contact pins which are provided to extend with their distal end through the contact plate, wherein each contact pin is spring-mounted with its proximal end relative to a mounting element, all this such that the contact pins can be pressed with their distal ends against the printed circuit board so as to set the spring-mounting at the position of the mounting element at least partially into action, wherein the contact pins are electrically connected to testing means.

Nowadays, printed circuit boards are integrated in many devices. Not just computers, but also domestic appliances, sensors, medical devices, vehicles and objects for use contain electronics these days. Electronic functions are in practice usually provided in a device by integrating one or more printed circuit boards in the device. A printed circuit board for a device is typically designed specifically and has a form and functionality adapted to the device. Because many different devices are produced in large numbers, many printed circuit boards are also produced in large numbers. In order to guarantee correct operation of the produced printed circuit boards, they are tested.

The testing of printed circuit boards is preferably incorporated into the production process of the printed circuit boards as a set step. It can hereby be prevented that a printed circuit board which does not function correctly is built into an appliance and ends up with an end user. On the one hand, the cost of the building in and of delivering this product to the end user is a lost cost when the printed circuit board does not work. On the other hand, the cost of the end user being dissatisfied with an appliance which does not function correctly is a cost that should not be underestimated. This is because the latter can entail considerable reputational damage, the cost of which is often difficult to measure.

Devices were therefore developed which can check the operation of the printed circuit boards during or after the production process of the printed circuit boards. For this purpose contact points are typically provided on printed circuit boards when they are designed. By performing predetermined tests at these contact points via testing means the correct operation of the printed circuit board can be ensured. The testing means are known and are therefore not described further in this description.

These known devices typically have a contact plate with a plurality of contact pins which can extend through the contact plate. The contact pins and the contact plate are usually made to size for a printed circuit board, such that the contact pins form a pattern corresponding to a pattern of the contact points on the printed circuit board. The contact points of the printed circuit board will hereby be aligned with the contact pins of the device when the printed circuit board is placed correctly on the contact plate. In order to ensure contact between each contact pin and corresponding contact point of the printed circuit board the contact pins are spring-mounted with their proximal end in a base. This base is mounted in a mounting element. The printed circuit board can hereby press with its contact points against the distal ends of the contact pins and thus press in the spring-mounting at the position of the proximal ends of the contact pins. The result will be that, within determined operational limits, all contact pins press against the contact points with a predetermined force, which is predetermined by the spring-mounting, when the printed circuit board is placed on the contact plate. This allows a printed circuit board to be tested in an operationally reliable manner.

Patent documents JPH02150773 A and DE3906691 A1 disclose probe pin structures for testing printed circuit boards wherein the probe pins are at least partially within sleeves. Patent document US3731191 A discloses an electrical test probe assembly comprising a flexible conductive probe wire within a bent conductive guide cylinder which is fixedly supported within a housing.

Electronic construction components are being made smaller and smaller. A result hereof is that printed circuit boards can be made smaller, with the same functionality. A further result is that printed circuit boards can comprise more functionalities at the same size. In practice, electrical lines and electronic functions will hereby lie closer together. The density of the functions and electrical lines becomes significantly greater. The direct result is that contact points also become smaller, and come to lie closer together.

A drawback of existing devices is that contact points must lie at a predetermined minimum distance from each other.

It is an object of the invention to provide a device whereby recent printed circuit boards can be tested in an economical and operationally reliable manner.

For this purpose the invention provides a device according to claim 1, wherein the plurality of contact pins comprise a first set with at least one contact pin and wherein each of the at least one contact pin is placed in a corresponding sleeve, which sleeve is fixedly connected at the position of the mounting element and at the position of the contact plate, and wherein the contact pin can be moved at least partially through the sleeve, wherein the mounting element comprises drive means for pushing the contact pins, via the spring-mounting, through the contact plate. According to a first embodiment, the drive means are formed by a fixed part and a movable part, wherein the sleeve is connected to the fixed part and the at least one contact pin is spring-mounted with its proximal end relative to the movable part of the mounting element.

The invention is based on the insight that spring-mountings at the position of the proximal ends of the contact pins are too thick for placing the contact pins close together in simple manner. This is because, when the contact pins are placed parallel to each other so as to together form the pattern at the contact plate, the contact pins cannot be placed together closer than the proximal ends can be placed together. In other words, the proximal ends with the spring-mounting form the widest parts of the contact pins, so that the proximal ends form the limiting factor for placing the contact pins closer together.

Another part of the invention is based on the insight that the contact pins become more susceptible to damage when they take a more compact and thinner form. Contact pins become damaged easily, particularly during placing of the printed circuit board on the contact plate. Contact pins can also become damaged easily during handling of the device, for instance for storage. It is therefore a considerable advantage if the contact pins can be retracted at least partially into the contact plate when placing and removing a printed circuit board on/from the contact plate.

The invention provides at least some of the contact pins, i.e. at least one contact pin, in a corresponding sleeve. The contact pins are movable in the sleeve. This construction allows deviation from a construction wherein the pins extend straight. In other words, the proximal end of the contact pin can be provided at a substantially random distance, location and orientation relative to the distal end of the contact pin. The contact pin extends between the mounting element on one side and the contact plate on the other, through the sleeve. In principle the construction is compared to that of a brake cable of a bicycle, this cable extending in a sleeve between the brake lever at the handlebars and the brake at the wheel. It is noted here that there is a difference because the forces and movements occur the other way around in a brake cable, a pulling force for contacting the brake pads instead of a pushing force for pressing the contact pins against the printed circuit board. The path followed by the cable, and the orientation of the cable at the position of the handlebars and at the position of the wheel, can be chosen freely. The same construction and advantage are obtained when the contact pins are placed in sleeves in the device.

Because the mounting element has a fixed part and a movable part in the device according to the invention, active or passive retraction of the contact pins is enabled. This is because the sleeves are connected to the fixed part, while the proximal ends are connected via their spring-mounting to the movable part. By moving the movable part relative to the fixed part the contact pins are moved through the sleeves. This is because the sleeves are connected to the fixed part and the contact pins are connected via their spring-mounting to the movable part. This allows the following action. Before placing of a printed circuit board the contact pins are retracted into the contact plate by moving the movable part away relative to the fixed part. The printed circuit board can hereby be moved and displaced on the contact plate without the possibility of contact pins thereby being touched, and thereby being damaged. In the retracted state the contact plate can be precisely aligned relative to the printed circuit board so that the contact pins are positioned correctly relative to the printed circuit board. After the printed circuit board has been correctly placed on the contact plate, the movable part is moved toward the fixed part so that the contact pins will hereby move outward through the contact plate. The contact pins hereby come up against the contact points on the printed circuit board. After the contact pins touch the printed circuit board, the spring-mounting of the contact pins will act to guarantee a predetermined pressure of the contact pins against the printed circuit board. In this state the printed circuit board can be tested. Following the test, the contact pins can be retracted by a movement of the movable part of the mounting element away from the fixed part, after which the printed circuit board can be safely removed or repositioned relative to the contact plate. This combination of advantages and insights allows more compact printed circuit boards to be tested in an economical and operationally reliable manner.

The movable part and the fixed part are preferably operatively connected to an actuator which is provided to move the proximal end of each of the at least one contact pin toward its sleeve and so move the contact pin through the contact plate. Via the actuator the device can extend the contact pins through and retract them from the contact plate automatically. The actuator can form part of the device, or can be an external actuator. The actuator will press the movable part toward the fixed part and actively move the contact pins from the contact plate. The return movement can be active or passive. An active return movement can be realized by having the actuator retract the movable part, whereby the movable part retracts the proximal ends with the spring-mounting. A passive return movement can be realized by providing the contact pins with a further spring-mounting which pushes the contact pins to a retracted position when an external force of the actuator is eliminated.

The device preferably has a carrier for the printed circuit board, wherein at least one of the carrier and the contact plate comprises positioning means for positioning the contact plate relative to the printed circuit board. The carrier can be formed by a frame in which the printed circuit board is held. A carrier can also be formed by a transport means, or other means for carrying and/or holding the printed circuit board. At least one of the carrier and the contact plate further preferably comprise position detection means for detecting a relative position of the printed circuit board relative to the contact plate. The carrier is provided to carry or hold the printed circuit board relative to the contact plate. Via the positioning means the contact plate can be placed at a predetermined position relative to the printed circuit board, or vice versa. The position detection means allow detection of the position of the printed circuit board relative to the carrier, and as a result also relative to the contact plate. The position detection means are further preferably provided to control the positioning means so as to position the printed circuit board at least partially automatically in a predetermined relative position relative to the carrier. Position detection means and the positioning means can be provided in the same or different components of the device. The carrier with combination of positioning means and position detection means thus allows a printed circuit board to be placed in a correct position relative to the contact plate automatically. It is particularly in a production context that this is a considerable advantage and that this allows the device to be placed in a production line in which successive printed circuit boards can be positioned and tested automatically.

Each of the at least one contact pin of the first set is located at the position of the contact plate on a first imaginary axis and at the position of the mounting element on a second imaginary axis, which differs from the first imaginary axis. On one hand this comprises of placing the distal end of the contact pin at an angle relative to the proximal end thereof. The angle is here for instance 90 degrees. On the other hand, this comprises of placing the distal end of the contact pin in the same direction, i.e. at an angle of 0 degrees, but with an offset relative to the proximal end thereof. This allows a simple placing and operation. This further simplifies the general construction of the device. The free choice of orientation and position of the contact pins at the position of the mounting element further allows creation of a wider support surface for the proximal ends of the contact pins. The skilled person will appreciate that the angle can also be different, for instance 15°. The angle could even be 180°, so that the direction of actuation of the contact pins is opposite to the direction in which the contact pins exit the contact plate.

The at least one contact pin preferably goes round a bend along at least a segment of its length. Going round a bend is only possible because the contact pin is surrounded by the sleeve. The sleeve goes round the bend together with the contact pin. The sleeve ensures that the distance for the contact pin, in length, between the contact plate and the fixed part of the mounting element remains substantially constant. This latter ensures the proper operation of the contact pin.

The plurality of contact pins preferably comprises a second set of contact pins, the proximal ends of which lie with the distal ends on the same imaginary axis. In other words, the proximal ends will lie substantially straight under the distal ends. A proximal end of each contact pin of the second set of contact pins is further preferably mounted in a base plate of the mounting element, this base plate being provided substantially parallel to the contact plate. The second set of contact pins allows those contact points on a printed circuit board which lie at a sufficiently great distance from each other to be contacted. The contact pins of the second set can be directly connected with their spring-mounting to the contact plate, and thus not be disposed in retractable manner. Alternatively, the contact pins of the second set are connected with their spring-mounting to a base plate under the contact plate. Having a contact pin run straight downward to a base plate is simple and inexpensive. The first set of contact pins running through a sleeve can then be used only when contact points lie close together. A combination of the first set and second set can thus be used to construct a device for testing a printed circuit board in cost-efficient manner.

The base plate is preferably movable relative to the contact plate via an actuator. For the contact pins of the second set the same advantage is thereby achieved as with the movement of the movable and fixed part of the mounting element.

The sleeve is preferably manufactured from polyether ether ketone (PEEK). PEEK has been found to have a high resistance to compression, while still being deformable. PEEK further has a high resistance to stretching, is wear-resistant an electrically insulating. This is a good combination of properties for making a sleeve for a contact pin. It has further been found that a sleeve can be manufactured from PEEK with a thin wall, which allows contact pins to be mounted close together.

The mounting element preferably has mounting openings which extend all the way through the mounting element and which are formed to allow mounting and dismounting of a contact pin with a base from a rear side. Mounting and dismounting on the rear side allows for considerably simpler maintenance of the device. A contact pin can hereby be replaced together with its base in very simple manner.

The fixed part of the mounting element is preferably provided with air blowing means for blowing air through the sleeves. By blowing air through the sleeves a bearing can on one hand be obtained, and it can further be prevented that dirt can find its way into the sleeve at the position of the distal ends of the contact pins. It will be apparent to the skilled person that the air blowing means do typically comprise an air chamber and typically also one or more connections and/or air channels. The air blowing means which generate the effective compressed air, the compressor elements, are typically located externally.

According to a further embodiment of the invention, the drive means are formed by pneumatic actuators at each of the at least one contact pin, wherein the pneumatic actuator is provided to push the contact pin and to form the spring-mounting. Similarly to a pneumatic spring-mounting, a pneumatic actuator can realize on one hand the position of a component, and also a spring-mounting. An example of such an embodiment is shown in the figures and described hereinbelow.

The invention will now be further described on the basis of an exemplary embodiment shown in the drawing.

In the drawing:
figure 1 shows a schematic diagram of a device according to an embodiment of the invention;
figure 2 shows a first embodiment of a mounting element with a fixed and movable part;
figure 3 shows a further embodiment of a mounting element with a fixed and movable part; and
figure 4 shows a second embodiment of a device wherein the drive means are embodied by pneumatic actuators.

The same or similar elements are designated in the drawing with the same reference numerals.

For interpretation of this patent text, the following definitions will apply. A printed circuit board is a collective name for different types of electronic building block. The most common electronic building block is board-shaped, although hybrid, wireframe, modules, 3D electronics and other electronic building blocks will also be deemed printed circuit boards. A contact plate is a component in the device which has a shape compatibility with the printed circuit board. Just as the printed circuit board is not necessarily board-shaped, the contact plate will likewise not necessarily be board-shaped, but can also be adapted to the shape of the printed circuit board, for instance block-shaped. A sleeve is defined as a hollow cylindrical or tubular element which functions as casing for a segment of a cable or wire.

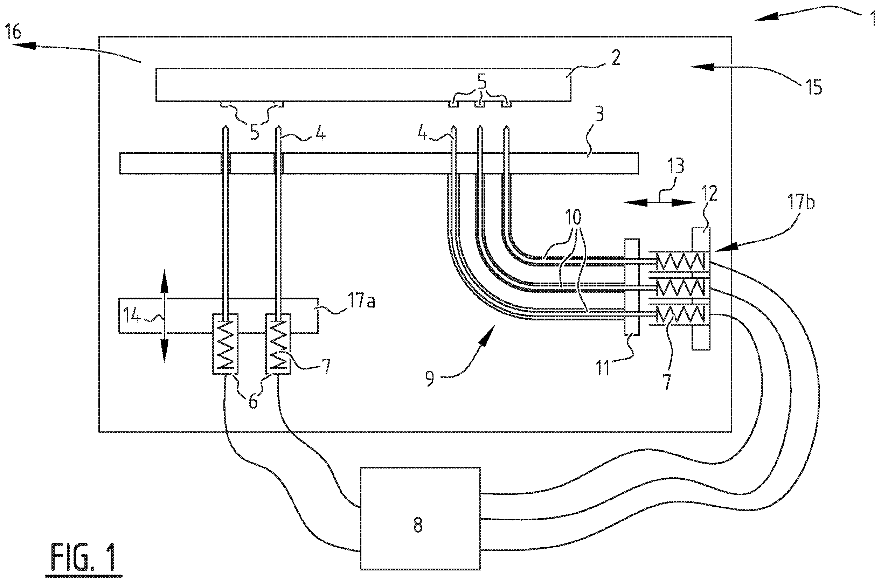

Figure 1 shows a device 1 according to an embodiment of the invention. Figure 1 is intended solely for the purpose of illustrating several operating principles. Figure 1 also illustrates the issue with the miniaturization of printed circuit boards. The figure is intended solely for the purpose of illustrating the operation of device 1. The skilled person will appreciate that a device with the shown principles can be formed and developed in different ways.

Figure 1 shows the device 1 with a printed circuit board infeed 15 and a printed circuit board outfeed 16. Printed circuit boards can be fed in and fed out continuously in successive cycles. The testing of the printed circuit board described hereinbelow will preferably also be performed in cyclical manner. Figure 1 illustrates a printed circuit board 2 which is positioned on a contact plate 3. Contact plate 3 is the plate having the contact pins 4 therein. Contact pins 4 are intended to make contact with contact points 5 on a printed circuit board 2 and thus test the operation of printed circuit board 2 via testing means 8. The device 1 is designed to test printed circuit boards in systematic manner in a production process. More specifically, printed circuit boards are produced in batches, and each printed circuit board of the batch is subjected to a predetermined number of tests in order to ensure that the printed circuit board functions correctly. Device 1 according to the invention allows these systematic tests to be performed in automatic manner. Device 1 according to the invention can further be used when printed circuit boards to be tested are fed in and/or fed out manually.

Figure 1 shows the contact plate 3 at a distance from the printed circuit board 2. Contact plate 3 will not necessarily make contact with printed circuit board 2 during normal operation of the device. Contact plate 3 can be constructed from one or more parts, optionally movable relative to each other, and forms at least a part of the guiding and/or positioning of contact pins 4. This guiding and/or positioning can be realized directly or indirectly, for instance via a bush. Contact pins 4 extend through contact plate 3. For this purpose contact plate 3 is provided with a plurality of openings in a predetermined pattern. The contact pins extend through the openings in contact plate 3. The distal ends of the contact pins thereby form a pattern which corresponds with a pattern of the contact points 5 on the printed circuit board 2 to be tested.

Contact pins 4 extend through contact plate 3. The pin tips, formed by the far ends of contact pins 4 at the position of their distal end, thereby form a pattern in an imaginary plane which lies parallel to contact plate 3 at a distance from the contact plate. Printed circuit board 2 is supplied via printed circuit board infeed 15. The printed circuit board is then positioned on a carrier (not shown). More specifically, the position of printed circuit board 2 relative to the carrier will be chosen such that the contact points 5 of printed circuit board 2 are brought in line with the contact pins 4. In order to realize this, different systems can be provided in device 1. A position detection system can thus be provided, which detects the position of the printed circuit board. The position detection system can take an optical or mechanical form. Optical markers can for instance be provided on printed circuit board 2 in order to facilitate positioning. For the invention the printed circuit board 2 is preferably positioned correctly and precisely relative to contact plate 3 in automatic manner. The manner in which this is done however does not form part of this invention. The skilled person is free to perform this aspect in different ways.

Following the positioning of printed circuit board 2 relative to contact plate 3, contact is made with points 5. This is done by a relative movement of contact pins 4 relative to printed circuit board 2. According to a first operating principle, the printed circuit board can in practice be moved toward the contact plate and thus come to lie on the contact pins. According to a second, preferred operating principle, contact pins 4 are moved outward from contact plate 3 while the contact plate and printed circuit board are remain in place. In a further alternative, third operating principle the contact plate is moved downward relative to and together with the printed circuit board while the contact pins are held in a fixed position, such that the contact pins move through the contact plate.

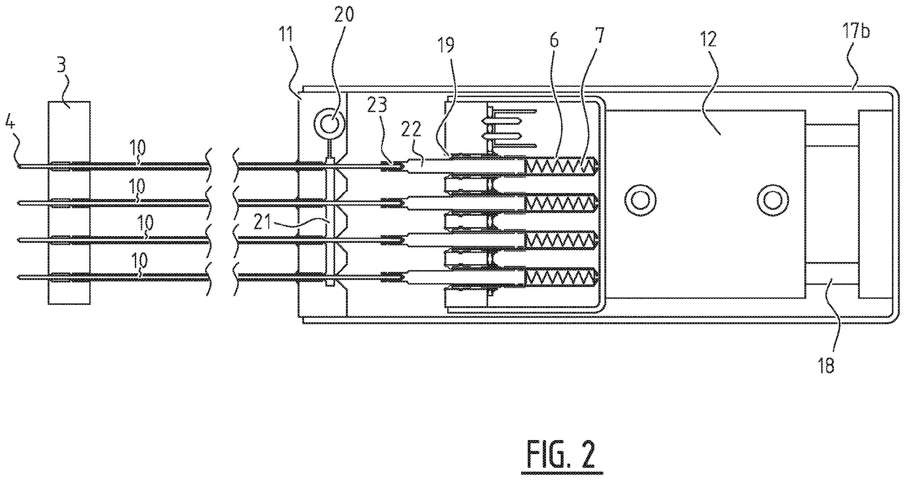

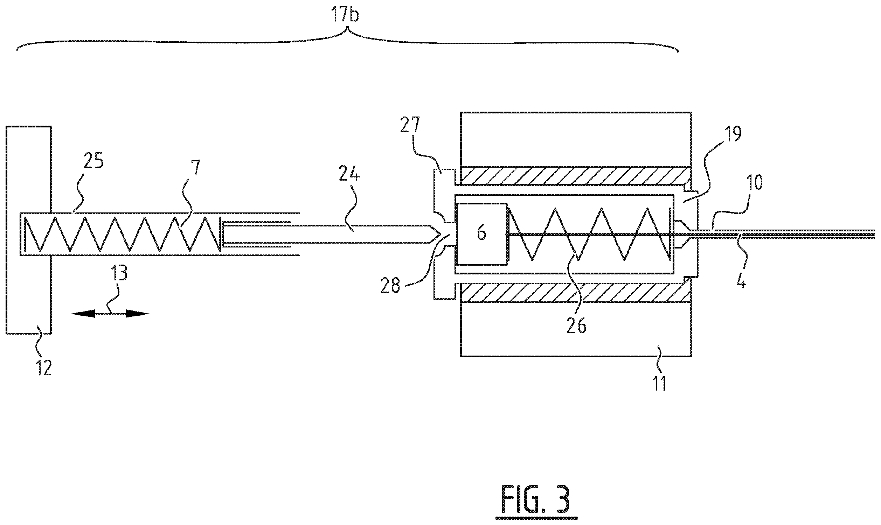

In order to guarantee that each contact pin 4 presses against its corresponding contact point 5 with a predetermined minimal force in order to guarantee a correct electrical connection between the contact point and the contact pin, the contact pin is arranged in spring-mounted manner. The result is that the relative movement of printed circuit board 2 relative to the contact pins almost stops after a contact pin comes up against the contact point, after which the spring-mounting of the contact pin absorbs a further movement. The spring-mounting 7 of the contact pins is provided at the position of the proximal end of each contact pin. According to a first embodiment as shown in figures 1 and 2, a base 6 with a spring-mounting, which will be further elucidated below, is provided for this purpose. In a second embodiment, as shown in figure 3, a base 6 is provided which is operatively compatible with a spring-mounting, but wherein the spring-mounting is not placed fixedly in or on the base 6. The above-described relative movement of the contact pin and the printed circuit board is preferably obtained by moving the bases of the contact pins relative to the printed circuit board with a predetermined stroke which is greater than the distance between the pin tip and the printed circuit board. During the movement of the base relative to the printed circuit board, the pin will hereby come to a standstill when the contact pin touches the printed circuit board, and the spring-mounting will absorb the remaining movement of the base relative to the printed circuit board. In other words, during the first part of the predetermined stroke the contact pin will co-displace in relative manner with the base relative to the printed circuit board. During the second part of the stroke the contact pin will be stationary relative to the printed circuit board, while the spring-mounting facilitates a relative movement between the contact pin and the base.

Base 6 forms a housing for the proximal end of contact pin 4. For this purpose the base has an elongate form with a bottom on one side and an open end on another side. The contact pin extends with its proximal end through the open end and into base 6. A coil spring 7 is preferably provided in base 6. The coil spring 7 is operatively connected to the contact pin. The contact pin can hereby be pressed in in the base, whereby the coil spring is compressed. When contact pin 4 is released, coil spring 7 will push contact pin 4 at least partially back outward.

Base 6 is mounted fixedly in a mounting element 17. Figure 1 shows two mounting elements 17a and 17b. Mounting element 17a is formed by a plate or holder which lies substantially parallel to contact plate 3 and at a relatively limited distance therefrom. This construction allows the bases 6 to be mounted fixedly in mounting element 17a, substantially perpendicularly below the contacting point where the contact pin protrudes through contact plate 3. In other words, the bases 6 can be formed in the same pattern as the contact pattern. This allows a simple and cost-efficient construction. The drawback is that the width or thickness of base 6 determines how close together the contact pins can lie in the pattern. Contact points 5 may lie closer together in practice, making a different construction desirable. This will be further elucidated below. Mounting element 17a can be moved relative to contact plate 3, shown with arrow 14, in order to press the contact pins against printed circuit board 2, as explained at length above.

Figure 1 shows mounting element 17b on the right-hand side. This mounting element 17b has a fixed part 11 and a movable part 12. Bases 6 are mounted fixedly in movable part 12. Mounting element 17b is mounted at a considerably greater distance from contact plate 3 than mounting element 17a. In order to guide contact pins 4 between mounting element 17b and contact plate 3, a sleeve 10 is provided for each contact pin 4. The sleeve is on one side connected fixedly to contact plate 3 and on the other connected fixedly to the fixed part 11 of the mounting element.

The sleeve 10 forms a hollow or tubular element in which the contact pin 3 fits. The sleeve is preferably flexible to some extent so that the sleeve can be bent. The sleeve is more preferably formed with a high resistance to compression and/or stretching, so that the length of the sleeve is substantially constant. The sleeve is further preferably manufactured from a material which forms an insulator for an electric voltage. The sleeve preferably functions analogously to a casing of a brake cable of a bicycle. The sleeve is preferably manufactured from a material which has one or more of the above stated properties when the sleeve has a small wall thickness. A small wall thickness is a wall thickness smaller than 0.5 mm, preferably smaller than 0.4 mm, more preferably smaller than 0.3 mm and most preferably smaller than 0.2 mm. An example of a material with which this is possible is polyether ether ketone (PEEK). PEEK is a material with which flexible sleeves can be manufactured with a total diameter smaller than 1.0 mm, preferably smaller than 0.5 mm, and with a wall thickness of about 0.1 mm. Such sleeves provide a high resistance to pressure and often have a smooth inner wall. They are therefore highly suitable to function as sleeve for contact pins.

Contact pin 4 is preferably a thin, flexible wire. The contact pin can bend owing to the flexibility of the sleeve in combination with the flexibility of the contact pin. This creates options for a designer to provide other operational means, such as a camera and/or a force supporting plate below or close to the location where contact pins are provided in the contact plate. This is because the contact pins and the sleeves can be bent away under the contact plate so that space and room is created for the operational means.

A sleeve 10 has a thickness which is considerably smaller than the width or thickness of base 6. Sleeves 10 can therefore be placed close together in a contact plate 3 in simple manner so that contact pins 4 can also lie close together. This is shown in figure 1 on the right-hand side of contact plate 3. Because sleeves 10 are flexible, it is further possible in simple manner to realize that the sleeves are placed further apart at the position of a mounting element 17b, so that bases 6 also lie further apart. It will be apparent that the terms 'close together' and 'further apart' are used in relative manner in relation to each other. In other words, adjacent contact pins will lie closer together at the position of contact plate 3 than at the position of mounting element 17b. All this allows the closeness or density of the contact pins 4 at the position of contact plate 3 to be greatly increased. This makes it possible to form a considerably finer pattern with the contact pins 4, so that contact points 5 which lie closer together can be contacted correctly. A greater force can thus be generated at the proximal end of the pin, and be transferred to the distal end which can there be placed at a smaller distance. This is the reason behind the concept, to then thus nevertheless be able to press with greater force than if this could be done directly on the small pitch.

Mounting element 17b comprises a fixed part 11 to which the sleeves are connected. Mounting element 17b further comprises a movable part 12 to which the contact pins 4 are connected via their bases 6. The fixed part 11 and movable part 12 are formed as parallel plates or bars. Movable part 12 is movable relative to fixed part 11, indicated with arrow 13. The simplest manner is to connect fixed part 11 to a frame and to connect the movable part via an actuator, optionally supported by one or more guides, to the frame or to the fixed part 11. Alternatively, the movable part 12 can be connected fixedly to the frame and the fixed part is movable in an absolute sense via an actuator relative to the fixed movable part 11. The fixed part is deemed such because the distance bridged by the contact pin between the fixed part and contact plate 3 is fixed due to the presence of the sleeves. Even when the fixed part is moved in absolute sense, the length of the sleeves will not change, but the flexibility of the sleeves can allow the movement. It therefore does not matter initially which of the fixed or movable part of the mounting element is moved in absolute sense. The terms fixed and movable are in a functional sense considered relative to the contact plate, which typically corresponds, though not necessarily so, to the absolute position in the device.

Because the sleeve is connected fixedly to contact plate 3 on one side and on the other connected fixedly to fixed part 11 of mounting element 17b, a relative movement of movable part 12 relative to fixed part 11 of the mounting element will also cause a relative movement of contact pins 4 relative to contact plate 3. This makes it possible to at least partially retract the contact pins into contact plate 3 by moving the movable part 12 away from fixed part 11. It also becomes possible to have the contact pins slide outward from contact plate 3 by moving the movable part 12 toward fixed part 11. These movements thus allow the same functionality and use as described above in respect of the mounting element 17a. During the movement of movable part 12 toward fixed part 11 the spring-mounting in base 6 will thus also begin to work when contact pin 4 comes up against contact point 5.

Testing means 8 are connected to each of the contact pins 4. Testing means 8 are preferably connected to the base 6 of each contact pin and thus make electrical contact via the base and optionally via the spring-mounting 7 to contact point 5 when contact pin 4 is pressed against the contact point 5. This is shown schematically in figure 1. Alternatively, testing means 8 are connected to a middle segment or distal segment of each contact pin 4. Various electrical connections and interfaces (not shown) can be coupled between the testing means and the contact pins. Figure 1 shows a setup wherein one contact plate 3 is disposed substantially horizontally so as to make contact with contact points 5 situated on the bottom of a printed circuit board 2. It will be apparent that the shown principles can be applied irrespective of the orientation of contact plate 3. The shown principles can also be applied when two contact plates 3 are placed opposite each other in order to sandwich a printed circuit board 2 between the contact plates 3 so as to be able to make contact with contact points 5 on either side of a printed circuit board 2 simultaneously. In such a configuration further positioning means can be provided in order to position at least one of the contact plates 3 relative to the printed circuit board 2.

Figure 2 shows mounting element 17b in more detail. Figure 2 shows here an embodiment wherein an actuator 18 is provided to move the movable part 12 relative to the fixed part 11. Figure 2 illustrates that contact pins 4 extend with a distal end through a contact plate 3. Between contact plate 3 and fixed part 11 the contact pins 4 are surrounded by a sleeve 10. Each sleeve 10 is connected to the contact plate 3 and to the fixed part 11 of mounting element 17b.

Each contact pin 4 is connected with a proximal end to the movable part 12 of mounting element 17. In the embodiment of figure 2 each base 6 has a spring 7 around which is provided a piston 22 with a clamp 23. The piston 22 is held movably in the base 6, wherein the spring 7 provides for a spring-mounting of the piston 22. The contact pin 4 is clamped in the clamp 23 so that contact pin 4 is connected via clamp 23 and piston 22 to base 6 in spring-mounted manner.

Each base 6 is connected via a mounting bush 19 to the movable part 12 of mounting element 17b. For this purpose a hole, in which mounting bush 19 is provided, is provided all the way through movable part 12. The mounting bush is provided such that the base 6 can be mounted on a side lying opposite the side adjacently of fixed part 11. In other words, base 6 can be mounted and dismounted from the back. The base can be removed from the mounting bush and from the movable part 12 of mounting element 17 via the rear side. Contact pin 4 can thus also be removed along with the base in simple manner. Mounting a new contact pin can thus also be done in simple manner on the rear side of the movable part 12 of mounting element 17b. This allows simple maintenance and repairs.

Compressed air is preferably provided at the position of mounting element 17b for blowing air at least partially through sleeves 10. An air chamber 21 is provided for this purpose in the fixed part 11 of mounting element 17b. Air chamber 21 is connected to the sleeves so that air can flow from air chamber 21 into sleeves 10. On the one hand this provides for a bearing of the sleeves. On the other, this ensures that dirt particles at the position of contact plate 3 cannot accidentally find their way into the sleeve. Due to the overpressure in the sleeves, air will flow from the distal ends of the sleeves at the position of the distal ends of the contact pins, so that dirt is blown or pushed away. This ensures a good operation of the device. Alternatively (not shown), an air chamber is formed at the position of or in the contact plate, adjacently of the openings where the distal ends of the contact pins are able to exit the contact plate, in order to prevent dirt particles from inadvertently ending up in the openings and/or in the sleeve.

Figure 3 shows an alternative embodiment. In figure 3 the above described operating principles are constructed in a different way. Figure 3 shows a mounting element 17b with a fixed part 11 and a movable part 12. In figure 3 a base 6 is connected fixedly to a proximal end of contact pin 4. This base 6 is placed movably or slidably in a mounting bush 19. A further spring 26 is here placed distally of the base in order to push base 6 and contact pin 4 to its most retracted position.

Sleeve 10 is connected to mounting bush 19. Mounting bush 19 is provided at the rear with covering means 27 with an opening 28. By removing the covering means the base 6 can be removed from the device together with the pin. This allows simple replacement of contact pins 4. Mounting bush 19, together with sleeve 10, can preferably be mounted in and removed from fixed part 11 from the front or from the rear. This simplifies manufacture and maintenance of the device.

At the position of covering means 27 a further contact pin 24 can press through opening 28 against the base 6 of contact pin 4. The further contact pin 24 forms together with the movable part 12 of the mounting element the drive means for pushing contact pin 4. Via further contact pin 24 the contact pin 4 is connected in spring-mounted manner to the movable part 12 of mounting element 17b when the further contact pin presses against base 6. Further contact pin 24 is proximally placed in a further base 25 with a spring 7. The spring 7 will have a higher resistance to compression than the further spring 26, such that spring 26 is pushed in when further contact pin 24 presses against base 6. The action at the position of contact plate 3 is as described above. Namely, while movable part 12 moves toward fixed part 11, contact pin 4 will come up against a contact point of a printed circuit board, after which continued movement of contact pin 4 is stopped. Continued movement of movable part 12 toward fixed part 11 is then absorbed in spring 7.

In the second embodiment in figure 3 the proximal end of the spring is spring-mounted relative to the movable part via the base. The sleeve is then preferably connected indirectly to fixed part 11 of the mounting element, that is via mounting bush 19. It will be apparent that in this description the term 'connected fixedly' does not mean that components cannot be released from one another. Elements which are connected fixedly during operation of the device can be detached from one another when the device is not operative.

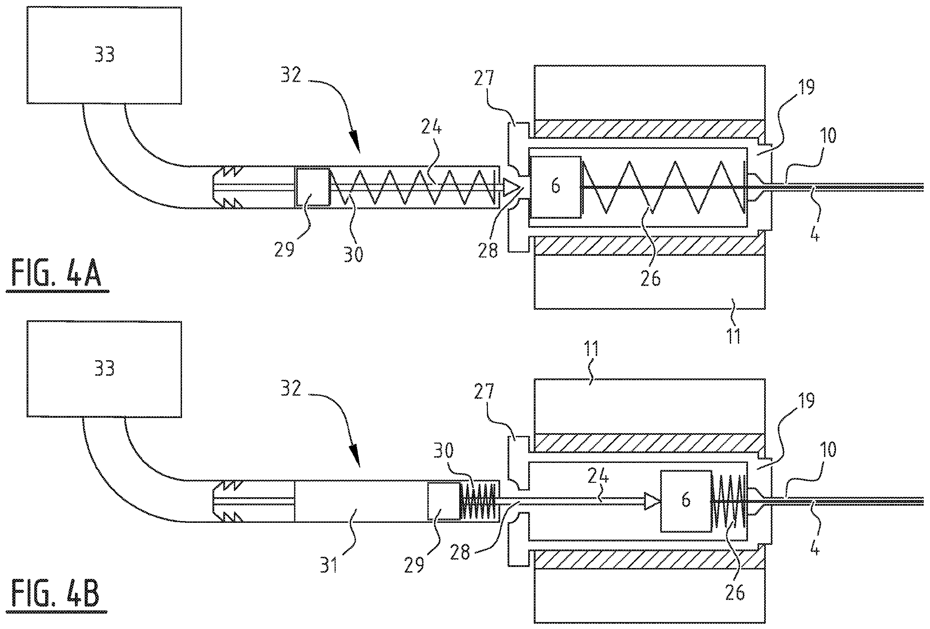

Figure 4 shows a second embodiment of a mounting element that can be applied as mounting element 17b in figure 1. This embodiment corresponds to the embodiment of figure 3, with the exception of the drive means. Figure 4A here shows the device in a state in which contact pin 4 is retracted, and figure 4B shows the device in a state in which contact pin 4 is extended. Figure 4 clearly shows that the mounting element comprises only a fixed part. The movable part has been rendered wholly unnecessary due to the altered drive means.

A pneumatic actuator 32 is provided in figure 4. This pneumatic actuator 32 comprises a housing with a piston 29. In the shown embodiment the piston is single-action. In order to ensure that the piston returns back to its retracted position after releasing or eliminating the compressed air the pneumatic actuator 32 is provided with a counter-pressure spring 30. A dual-action piston can alternatively be provided, this having an air chamber on two sides of the piston 29 in order to move the piston in two directions.

Pneumatic actuator 32 is connected via compressed air lines to a pneumatic controller 33. This pneumatic controller controls the compressed air pressure on piston 32. More specifically, the pneumatic controller controls the pressure in air chamber 31. The pressure in air chamber 31 provides on the one hand for a displacement of piston 29, which presses further contact pin 24 against base 6 and thus pushes contact pin 4 forward. On the other hand, the pressure in air chamber 31 provides for a spring-mounting, wherein the force of the spring-mounting depends on the air pressure in air chamber 31 and on the surface of piston 29. By applying a predetermined air pressure to pneumatic actuator 32 via pneumatic controller 33 the contact pin 4 is pressed with a predetermined force against the contact point 5 of the printed circuit board. The skilled person will appreciate here that the distance travelled by piston 29 by the application of an air pressure, as compared to the previous embodiments, is the same as the distance travelled by the movable part 12 minus the compression of spring-mounting 7. The amount of air pressure is directly related to the spring pressure of spring-mounting 7. The pneumatic actuators thus provide for both the movement and the spring-mounting of contact pin 4. The pneumatic actuators can be connected fixedly to the mounting element.

In all embodiments one or more contact pins can be provided with separately controllable actuators. The mounting element can be formed in several separately actuable segments. Contact pins can thus be operated and used individually or in predetermined blocks.

The skilled person will appreciate on the basis of the above description that the invention can be embodied in different ways.

The invention is not limited to the above described embodiments. The above described embodiments and the figures are purely illustrative and serve only to increase understanding of the invention. The invention will not therefore be limited to the embodiments described herein, but is defined in the claims.

## Claims

1. Device (1) for testing a printed circuit board (2), the device comprising a contact plate (3) and a plurality of contact pins (4) which are provided to extend with their distal end through the contact plate,
wherein each contact pin is spring-mounted with its proximal end relative to a mounting element (17,17a,17b), all
this such that the contact pins can be pressed with their distal ends against the printed circuit board so as to set the spring-mounting (7) at the position of the mounting element at least partially into action,
wherein the contact pins are electrically connected to testing means (8), wherein the plurality of contact pins comprise a first set with at least one contact pin and wherein each of the at least one contact pin is placed in a corresponding sleeve (10),
which sleeve is fixedly connected at the position of the mounting element and at the position of the contact plate, and wherein the contact pin can be moved at least partially through the sleeve, wherein the mounting element comprises drive means (12,24 ; 24,32,33) for pushing the contact pins, via the spring-mounting, through the contact plate; **characterized in that**:
each of the at least one contact pin is located at the position of the contact plate on a first imaginary axis and is located at the position of the mounting element on a second imaginary axis, which differs from the first imaginary axis.

2. Device according to the foregoing claim, wherein the drive means are formed by providing the mounting element with a fixed part and a movable part, wherein the sleeve is connected to the fixed part and the at least one contact pin is spring-mounted with its proximal end relative to the movable part of the mounting element.

3. Device according to the foregoing claim, wherein the movable part and the fixed part are operatively connected to an actuator which is provided to move the proximal end of the at least one contact pin toward the sleeve and so move the contact pin through the contact plate.

4. Device according to claim 1, wherein the drive means are formed by pneumatic actuators at each of the at least one contact pin, wherein the pneumatic actuator is provided to push the contact pin and to form the spring-mounting.

5. Device according to any one of the foregoing claims, wherein the device has a carrier for the printed circuit board, wherein at least one of the carrier and the contact plate comprises positioning means for positioning the contact plate relative to the printed circuit board.

6. Device according to the foregoing claim, wherein at least one of the carrier and the contact plate comprises position detection means for detecting a relative position of the printed circuit board relative to the contact plate.

7. Device according to the foregoing claim, wherein the position detection means are provided to control the positioning means so as to position the printed circuit board at least partially automatically in a predetermined relative position relative to the printed circuit board.

8. Device according to the foregoing claim, wherein the at least one contact pin goes round a bend along at least a segment of its length so that the first imaginary axis lies at an angle relative to the second imaginary axis.

9. Device according to any one of the foregoing claims, wherein the plurality of contact pins comprises a second set of contact pins, the proximal ends of which lie with the distal ends on the same imaginary axis.

10. Device according to the foregoing claim, wherein a proximal end of each contact pin of the second set of contact pins is mounted in a base plate of the mounting element, this base plate being provided substantially parallel to the contact plate.

11. Device according to the foregoing claim, wherein the base plate is movable relative to the contact plate via an actuator.

12. Device according to any one of the foregoing claims, wherein the sleeve is manufactured from polyether ether ketone (PEEK).

13. Device according to any one of the foregoing claims, wherein the mounting element has mounting openings which extend all the way through the mounting element and which are formed to allow mounting and dismounting of a contact pin from a rear side.

14. Device according to any one of the foregoing claims, wherein the fixed part of the mounting element is provided with air blowing means for blowing air through the sleeves.

## Patentansprüche

1. Vorrichtung (1) zum Prüfen einer Leiterplatte (2), die Vorrichtung umfassend eine Kontaktplatte (3) und eine Vielzahl von Kontaktstiften (4), die bereitgestellt sind, um sich mit ihrem distalen Ende durch die Kontaktplatte zu erstrecken, wobei jeder Kontaktstift mit seinem proximalen Ende relativ zu einem Befestigungselement (17, 17a, 17b) federnd befestigt ist, all dies derart, dass die Kontaktstifte mit ihren distalen Enden gegen die Leiterplatte gedrückt werden können, um die Federbefestigung (7) an der Position des Befestigungselements mindestens teilweise in Aktion zu versetzen, wobei die Kontaktstifte mit Prüfmitteln (8) elektrisch verbunden sind,
wobei die Vielzahl von Kontaktstiften einen ersten Satz mit mindestens einem Kontaktstift umfasst und wobei jeder des mindestens einen Kontaktstifts in einer entsprechenden Muffe (10) platziert ist,
wobei die Muffe an der Position des Befestigungselements und an der Position der Kontaktplatte fest verbunden ist, und wobei der Kontaktstift mindestens teilweise durch die Muffe bewegt werden kann, wobei das Befestigungselement Antriebsmittel (12, 24; 24, 32, 33) zum Drücken der Kontaktstifte über die Federbefestigung durch die Kontaktplatte umfasst;
**dadurch gekennzeichnet, dass:**
sich jeder des mindestens einen Kontaktstifts an der Position der Kontaktplatte auf einer ersten imaginären Achse befindet und sich an der Position des Befestigungselements auf einer zweiten imaginären Achse befindet, die sich von der ersten imaginären Achse unterscheidet.

2. Vorrichtung nach dem vorstehenden Anspruch, wobei die Antriebsmittel dadurch ausgebildet sind, dass das Befestigungselement mit einem festen Teil und einem beweglichen Teil bereitgestellt ist, wobei die Muffe mit dem festen Teil verbunden ist und der mindestens eine Kontaktstift mit seinem proximalen Ende relativ zu dem beweglichen Teil des Befestigungselements federnd befestigt ist.

3. Vorrichtung nach dem vorstehenden Anspruch, wobei der bewegliche Teil und der feste Teil mit einem Aktuator wirkverbunden sind, der bereitgestellt ist, um das proximale Ende des mindestens einen Kontaktstifts in Richtung der Muffe zu bewegen und so den Kontaktstift durch die Kontaktplatte zu bewegen.

4. Vorrichtung nach Anspruch 1, wobei die Antriebsmittel durch pneumatische Aktuatoren an jedem des mindestens einen Kontaktstifts ausgebildet sind, wobei der pneumatische Aktuator bereitgestellt ist, um die Kontaktstifte zu verschieben und die Federbefestigung auszubilden.

5. Vorrichtung nach einem der vorstehenden Ansprüche, wobei die Vorrichtung einen Träger für die Leiterplatte aufweist, wobei mindestens eines des Trägers und der Kontaktplatte Positionierungsmittel zum Positionieren der Kontaktplatte relativ zu der Leiterplatte umfasst.

6. Vorrichtung nach dem vorstehenden Anspruch, wobei mindestens eines des Trägers und der Kontaktplatte Positionserkennungsmittel zum Erkennen einer relativen Position der Leiterplatte relativ zu der Kontaktplatte umfasst.

7. Vorrichtung nach dem vorstehenden Anspruch, wobei die Positionserkennungsmittel bereitgestellt sind, um die Positionierungsmittel so zu steuern, dass die Leiterplatte mindestens teilweise automatisch in einer vorgegebenen relative Position relativ zu der Leiterplatte positioniert wird.

8. Vorrichtung nach dem vorstehenden Anspruch, wobei der mindestens eine Kontaktstift auf mindestens einem Abschnitt seiner Länge um eine Kurve geht, so dass die erste imaginäre Achse in einem Winkel relativ zu der zweiten imaginären Achse liegt.

9. Vorrichtung nach einem der vorstehenden Ansprüche, wobei die Vielzahl von Kontaktstiften einen zweiten Satz von Kontaktstiften umfasst, deren proximale Enden mit den distalen Enden auf derselben imaginären Achse liegen.

10. Vorrichtung nach dem vorstehenden Anspruch, wobei ein proximales Ende jedes Kontaktstifts des zweiten Satzes von Kontaktstiften in einer Grundplatte des Befestigungselements befestigt ist, wobei diese Grundplatte im Wesentlichen parallel zu der Kontaktplatte bereitgestellt ist.

11. Vorrichtung nach dem vorstehenden Anspruch, wobei die Grundplatte über einen Aktuator relativ zu der Kontaktplatte beweglich ist.

12. Vorrichtung nach einem der vorstehenden Ansprüche, wobei die Muffe aus Polyetherketon (PEEK) hergestellt ist.

13. Vorrichtung nach einem der vorstehenden Ansprüche, wobei das Befestigungselement Befestigungsöffnungen aufweist, die sich vollständig durch das Befestigungselement erstrecken und ausgebildet sind, um die Befestigung und Demontage eines Kontaktstifts von einer Rückseite aus zu ermöglichen.

14. Vorrichtung nach einem der vorstehenden Ansprüche, wobei der feste Teil des Befestigungselements mit Luftblasmitteln zum Blasen von Luft durch die Muffen bereitgestellt ist.

## Revendications

1. Dispositif (1) permettant de tester une carte de circuit imprimé (2), le dispositif comprenant une plaque de contact (3) et une pluralité de broches de contact (4)
qui sont prévues de manière à s'étendre par leur extrémité distale à travers la plaque de contact, dans lequel chaque broche de contact est montée sur ressort par son extrémité proximale par rapport à un élément de montage (17, 17a, 17b), tout cela de telle sorte que les broches de contact peuvent être pressées par leurs extrémités distales contre la carte de circuit imprimé de manière à activer au moins partiellement le montage sur ressort (7)
à la position de l'élément de montage au moins partiellement activé, dans lequel les broches de contact sont connectées électriquement à des moyens de test (8),
dans lequel la pluralité de broches de contact comprend un premier ensemble doté d'au moins une broche de contact et dans lequel chaque broche parmi l'au moins une broche de contact est placée dans un manchon (10) correspondant,
lequel manchon est connecté de manière fixe à la position de l'élément de montage et à la position de la plaque de contact, et dans lequel la broche de contact peut être déplacée au moins partiellement à travers le manchon, dans lequel l'élément de montage comprend des moyens d'entraînement (12, 24 ; 24, 32, 33) permettant de pousser les broches de contact, par le biais du montage sur ressort, à travers la plaque de contact ; **caractérisé en ce que** :
chaque broche parmi l'au moins une broche de contact est située à la position de la plaque de contact sur un premier axe imaginaire et est située à la position de l'élément de montage sur un second axe imaginaire, qui est différent du premier axe imaginaire.

2. Dispositif selon la revendication précédente, dans lequel les moyens d'entraînement sont formés en dotant l'élément de montage d'une partie fixe et d'une partie mobile, dans lequel le manchon est connecté à la partie fixe et l'au moins une broche de contact est montée sur ressort par son extrémité proximale par rapport à la partie mobile de l'élément de montage.

3. Dispositif selon la revendication précédente, dans lequel la partie mobile et la partie fixe sont connectées fonctionnellement à un actionneur qui est prévu pour déplacer l'extrémité proximale de l'au moins une broche de contact vers le manchon et déplacer ainsi la broche de contact à travers la plaque de contact.

4. Dispositif selon la revendication 1, dans lequel les moyens d'entraînement sont formés par des actionneurs pneumatiques au niveau de chaque broche parmi l'au moins une broche de contact, dans lequel l'actionneur pneumatique est prévu pour pousser la broche de contact et pour former le montage sur ressort.

5. Dispositif selon l'une quelconque des revendications précédentes, dans lequel le dispositif a un support pour la carte de circuit imprimé, dans lequel au moins l'un parmi le support et la plaque de contact comprend des moyens de positionnement permettant de positionner la plaque de contact par rapport à la carte de circuit imprimé.

6. Dispositif selon la revendication précédente, dans lequel au moins l'un parmi le support et la plaque de contact comprend des moyens de détection de position permettant de détecter une position relative de la carte de circuit imprimé par rapport à la plaque de contact.

7. Dispositif selon la revendication précédente, dans lequel les moyens de détection de position sont prévus pour commander les moyens de positionnement de manière à positionner la carte de circuit imprimé au moins partiellement automatiquement dans une position relative prédéterminée par rapport à la carte de circuit imprimé.

8. Dispositif selon la revendication précédente, dans lequel l'au moins une broche de contact s'étend en courbe le long d'au moins un segment de sa longueur de sorte que le premier axe imaginaire se situe à un angle par rapport au second axe imaginaire.

9. Dispositif selon l'une quelconque des revendications précédentes, dans lequel la pluralité de broches de contact comprend un second ensemble de broches de contact, dont les extrémités proximales se situent avec les extrémités distales sur le même axe imaginaire.

10. Dispositif selon la revendication précédente, dans lequel une extrémité proximale de chaque broche de contact du second ensemble de broches de contact est montée dans une plaque de base de l'élément de montage, cette plaque de base étant prévue sensiblement parallèlement à la plaque de contact.

11. Dispositif selon la revendication précédente, dans lequel la plaque de base est déplaçable par rapport à la plaque de contact par le biais d'un actionneur.

12. Dispositif selon l'une quelconque des revendications précédentes, dans lequel le manchon est fabriqué à partir de polyéthercétone (PEEK).

13. Dispositif selon l'une quelconque des revendications précédentes, dans lequel l'élément de montage a des ouvertures de montage qui s'étendent d'un bout à l'autre de l'élément de montage à travers celui-ci et qui sont formées pour permettre le montage et le démontage d'une broche de contact à partir d'un côté arrière.

14. Dispositif selon l'une quelconque des revendications précédentes, dans lequel la partie fixe de l'élément de montage est dotée de moyens de soufflage d'air permettant de souffler de l'air à travers les manchons.
